# EUROPÄISCHE PATENTSCHRIFT

(11) **EP 2 585 843 B1**
(45) Veröffentlichungstag und Bekanntmachung des Hinweises auf die Patenterteilung: **22.08.2018**
(21) Anmeldenummer: 11728184.0
(22) Anmeldetag: 24.06.2011
(51) Int. Cl.: G01R 33/28, G01R 33/62, A61B 5/055, G01N 24/12, G01R 33/56

(54) **HYPERPOLARISATIONSEINRICHTUNG UND VERFAHREN ZUR VERABREICHUNG EINES HYPERPOLARISIERTEN FLÜSSIGEN KONTRASTMITTELS**
HYPERPOLARISATION DEVICE AND METHOD FOR ADMINISTERING A HYPERPOLARISED LIQUID CONTRAST AGENT
INSTALLATION D'HYPERPOLARISATION ET PROCÉDÉ D'ADMINISTRATION D'UN AGENT DE CONTRASTE LIQUIDE HYPERPOLARISÉ

(30) Priorität: 24.06.2010 DE 102010017568
(43) Veröffentlichungstag der Anmeldung: 01.05.2013
(73) Patentinhaber: Johann Wolfgang Goethe-Universität Frankfurt am Main, 60325 Frankfurt am Main (DE)
(72) Erfinder: KRUMMENACKER, Jan, 66701 Beckingen (DE); PRISNER, Thomas, 61118 Bad Vilbel (DE); DENYSENKOV, Vasyl, 60439 Frankfurt am Main (DE); SCHREIBER, Laura, 55128 Mainz (DE); MÜNNEMANN, Kerstin, 55234 Monzernheim (DE)
(74) Vertreter: Lucke, Andreas
(86) Internationale Anmeldenummer: PCT/EP2011/003125
(87) Internationale Veröffentlichungsnummer: WO 2011/160853

(56) Entgegenhaltungen:
- EP-A1- 1 746 431
- EP-A1- 2 119 457
- US-A- 5 603 320
- VAHALA E ET AL: "A Study of the Use of Overhauser Enhancement to Assist with Needle and Catheter Placement during Interventional MRI", JOURNAL OF MAGNETIC RESONANCE, ACADEMIC PRESS, ORLANDO, FL, US, Bd. 157, Nr. 2, 1. August 2002 (2002-08-01), Seiten 298-303, XP004408078, ISSN: 1090-7807, DOI: 10.1006/JMRE.2002.2595
- DENYSENKOV V ET AL: "Liquid state DNP using a 260 GHz high power gyrotron", PHYSICAL CHEMISTRY CHEMICAL PHYSICS ROYAL SOCIETY OF CHEMISTRY UK, Bd. 12, Nr. 22, 14. Juni 2010 (2010-06-14) , Seiten 5786-5790, XP002659804, ISSN: 1463-9076
- STEVENSON S ET AL: "13C DYNAMIC NUCLEAR POLARIZATION: AN ALTERNATIVE DETECTOR FOR RECYCLED-FLOW NMR EXPERIMENTS", ANALYTICAL CHEMISTRY, AMERICAN CHEMICAL SOCIETY, US, Bd. 70, Nr. 13, 1. Juli 1998 (1998-07-01), Seiten 2623-2628, XP000776696, ISSN: 0003-2700, DOI: 10.1021/AC971337V
- WOLBER J ET AL: "Generating highly polarized nuclear spins in solution using dynamic nuclear polarization", NUCLEAR INSTRUMENTS & METHODS IN PHYSICS RESEARCH, SECTION - A:ACCELERATORS, SPECTROMETERS, DETECTORS AND ASSOCIATED EQUIPMENT, ELSEVIER, AMSTERDAM, NL, Bd. 526, Nr. 1-2, 21. Juni 2004 (2004-06-21), Seiten 173-181, XP004830097, ISSN: 0168-9002, DOI: 10.1016/J.NIMA.2004.03.171

## Beschreibung

### GEBIET DER ERFINDUNG

Die vorliegende Erfindung liegt auf dem Gebiet der Magnetresonanztomografie (MRT). Genauer betrifft sie eine Einrichtung zur Hyperpolarisation eines flüssigen NMR-Kontrastmittels und ein Verfahren zum Verabreichen eines hyperpolarisierten flüssigen Kontrastmittels.

### STAND DER TECHNIK

Die Magnetresonanztomografie (MRT) ist ein bildgebendes Verfahren, das vor allem in der medizinischen Diagnostik zur Darstellung von Strukturen und Funktionen von Gewebe und Organen im Körper eingesetzt wird. Die MRT basiert auf den Prinzipien der Kernspinresonanzspektroskopie, die üblicherweise als NMR(Nuclear Magnetic Resonance)-Spektroskopie bezeichnet wird. Bei dem Verfahren befindet sich das zu untersuchende Gewebe in einem starken statischen Magnetfeld, in welchem sich die Spins von Atomkernen im untersuchten Gewebe ausrichten, was zu einer Magnetisierung führt. Durch eine resonante Anregung mit einem elektromagnetischen Wechselfeld im Radiofrequenzbereich lässt sich die Magnetisierung aus der Richtung des statischen Feldes auslenken. In Folge der Anregung beginnen die Spins um die Richtung des statischen Magnetfeldes zu präzedieren, und die Präzession der Gesamtmagnetisierung kann mit Hilfe einer Spule als Spannungssignal gemessen werden. Wenn das hochfrequente Wechselfeld abgeschaltet wird, relaxieren die Spins wieder in den Ausgangszustand. Für diese Relaxation benötigen sie eine charakteristische Abklingzeit, die typisch für verschiedene Elemente und verschiedene Verbindungen ist und detektiert werden kann. Aus dieser Abklinginformation kann dann ein tomografisches Bild konstruiert werden. Die Magnetisierung der Kernspins im externen Magnetfeld ist ein statistischer Prozess, der der Boltzmann Verteilung gehorcht. Da die Energie der Wechselwirkung zwischen den Kernspins und dem statischen Magnetfeld verglichen mit der thermischen Energie bei Raumtemperatur verhältnismäßig klein ist, ist die Gesamtmagnetisierung durch das statische Magnetfeld ebenfalls verhältnismäßig klein, was zu Lasten des NMR-Signales geht.

Eine Methode, die Empfindlichkeit der NMR zu steigern besteht darin, die Stärke des statischen Magnetfelds zu erhöhen, wodurch eine weniger gleichmäßige Besetzung der Kernspinzustände erreicht wird. Allerdings sind der Stärke des Magnetfeldes technische Grenzen gesetzt, typischerweise beträgt sie in modernen MRT-Geräten 1,5 T. Bei Magnetfeldstärken von über 3,0 T können die Patienten nur sehr langsam in den Magneten gefahren werden, um induzierte Wirbelströme beispielsweise im Gehirn des Patienten zu minimieren.

Eine weitere Maßnahme zur Erhöhung der Empfindlichkeit besteht darin, die Probe stärker zu polarisieren, als dies der thermischen Besetzung der Spinzustände im gegebenen Magnetfeld entspricht. Eine Probe, bei der die Besetzung ein oder mehrerer Spinzustände gegenüber den anderen Spinzuständen deutlich stärker überwiegt, als ihre Energiedifferenz gemäß der Boltzmann Statistik vorhersagt, nennt man hyperpolarisiert.

In der MRT ist es bekannt, einem zu untersuchenden Lebewesen, d. h. einem Patienten oder zu untersuchenden Tier, ein hyperpolarisiertes Fluid zu verabreichen, das um mehrere Größenordnungen verstärkte NMR-Signale erzeugt. Ein derartiges hyperpolarisiertes Fluid wird in Anlehnung an die Terminologie aus der Röntgendiagnostik auch als "Kontrastmittel" bezeichnet. Als Kontrastmittel werden überwiegend Gase verwendet. Es ist jedoch auch bekannt, hyperpolarisierte Flüssigkeiten in das zu untersuchende Lebewesen zu injizieren.

Eine bekannte Technik, das Kontrastmittel zu hyperpolarisieren stellt die sogenannte dynamische Kernpolarisierung (Dynamic Nuclear Polarisation, DNP) dar. Bei der DNP werden zunächst Elektronenspins in einem äußeren Magnetfeld polarisiert. Durch resonante Anregungen der Elektronenspins im Mikrowellenbereich kann die Elektronenspinpolarisierung auf die Kernspins mittels einer schwachen Wechselwirkung zwischen den Elektronen und den Kernen übertragen werden. Die zugrundeliegenden Mechanismen sind als Overhauser-Effekt, Solid-Effekt, Cross-Effekt und sogenanntes "Thermal Mixing" bekannt.

Hierbei ist es üblich, das Kontrastmittel im gefrorenen Zustand und in einem verhältnismäßig starken statischen Magnetfeld von beispielsweise 3,35 T zu polarisieren. Bei diesen Bedingungen können die Kernspins erheblich stärker als im flüssigen Zustand polarisiert werden. Um das hyperpolarisierte Kontrastmittel jedoch verabreichen zu können, muss es zunächst aufgetaut und zum Patienten transportiert werden. Dabei tritt das Problem auf, dass ein wesentlicher Teil der Hyperpolarisierung durch Relaxationsprozesse beim Transport verloren geht. Außerdem ist das aus dem Stand der Technik bekannte Verfahren verhältnismäßig aufwendig.

Die EP 2 119 457 A1 offenbart eine Einrichtung und ein Verfahren zur Hyperpolarisation eines NMR-Kontrastmittels. Darin wird ein NMR-Kontrastmittel im festen Aggregatzustand bei Temperaturen von wenigen Kelvin in einem Mikrowellen-Resonator hyperpolarisiert und nachfolgend in einer warmen Flüssigkeit, beispielsweise Wasser, aufgelöst und einem Menschen oder Tier verabreicht. In einer Ausführungsform geschieht die Hyperpolarisierung mittels Festkörper-DNP in einem Mikrowellen-Resonator, der mit 70 GHz betrieben wird, in einem äußeren Magnetfeld von 2,5 T und bei einer Temperatur von 4,2 K. Die Hyperpolarisierung kann unter Verwendung desselben Magnetfeldes durchgeführt werden, welches auch für eine nachfolgende NMR-Bildgebung verwendet wird.

In DENYSENKOV et al: "Liquid state DNP using a 260 GHz high power gyrotron", Physical Chemistry Chemical Physics Royal Society of Chemistry UK, Bd. 12, Nr. 22, 14. Juni 2010 (2010-06-14), Seiten 5786-5790, ISSN: 1463-9076 werden DNP-Resultate für flüssige Proben unter Verwendung einer Hochleistungs-Gyrotron-Mikrowellenquelle vorgestellt, die mit einer Leistung von 20 W bei 260 GHz betrieben wird. Eine DNP-Verstärkung von -29 für Wasserprotonen wurde bei einer wässrigen Lösung des Fremy-Salzes gefunden.

In VAHALA et al: "A study of the use of Overhauser enhancement to assist with needle and catheter placement during interventional MRI", Journal ofMagnetic Resonance, Academic Press, Orlando, Fl, US, Bd. 157, Nr. 2, 1. August 2002 (2002-08-01), Seiten 298-303, XP004408078, ISSN: 1090-7807, DOI: 10.1006/JMRE.2002.2595 wurde eine wasserbasierte isotonische Trityl-Lösung in einem Glasbehälter hyperpolarisiert. Dazu wurde der Glasbehälter in einen Mikrowellen-Resonator gebracht, der in einem äußeren Magnetfeld mit einer Stärke von 0,23 T mit einer Mikrowellenfrequenz von 6,45 GHz betrieben wurde. Der Mikrowellen-Resonator hatte eine Güte von 100. Nach der Hyperpolarisierung wurde die in dem Glasbehälter befindliche Lösung mithilfe eines Propulsionsmechanismus aus dem Behälter und in ein Röhrchen mit einem Durchmesser von 1 mm verbracht, welches die hyperpolarisierte Lösung zu einer Probe führt. Der Propulsionsmechanismus funktionierte nach dem Prinzip eines Schießbogens mit Bogenstange und Bogensehne. Auch hier wurde die Hyperpolarisierung im selben Magnetfeld durchgeführt, in dem nachträglich die NMR-Bildgebung durchgeführt wurde.

### ZUSAMMENFASSUNG DER ERFINDUNG

Der Erfindung liegt die Aufgabe zugrunde, das oben beschriebene Problem der Polarisationsverluste zu lösen. Diese Aufgabe wird durch ein Verfahren nach Anspruch 1 und eine Einrichtung zur Hyperpolarisation eines flüssigen NMR-Kontrastmittels nach Anspruch 4 gelöst. Vorteilhafte Weiterbildungen sind in den abhängigen Ansprüchen angegeben.

Bei dem erfindungsgemäßen Verfahren wird ein flüssiges Kontrastmittel durch eine Leitung geleitet, die sich entlang einer Längsachse eines Mikrowellenresonators (MW-Resonator) erstreckt, der in dem statischen Magnetfeld desselben MRT-Gerätes angeordnet ist, in dem sich auch das zu untersuchende Lebewesen befindet. In den MW-Resonator wird eine Mikrowelle von mindestens 40 GHz eingekoppelt, die geeignet ist, das flüssige Kontrastmittel beim Durchfluss durch die Leitung im MW-Resonator mittels DNP zu polarisieren. Streng genommen wird die Flüssigkeit erst durch diese Polarisierung zu einem "Kontrastmittel", aber diese sprachliche Unterscheidung wird der Einfachheit halber im Folgenden nicht gemacht. Ferner wird das Kontrastmittel zumindest phasenweise in einem kontinuierlichen Durchfluss im MW-Resonator polarisiert zum Zweck der unmittelbaren Verabreichung an das zu untersuchende Objekt im MRT. Dabei wird im MW-Resonator eine MW-Mode ausgebildet, die entlang zumindest des überwiegenden Teils der Längsachse des Resonators einen Bauch in der Magnetfeldstärke und einen Knoten in der elektrischen Feldstärke aufweist. Dabei sind die Leistung der eingebrachten Mikrowelle und die Einkopplung der Mikrowelle in den Resonator so abgestimmt, dass sich im Bereich zumindest eines Abschnittes der Leitung eine Amplitude der MW-Magnetfeldstärke ergibt die einen Wert von mindestens 1·10⁻⁵ T, vorzugsweise mindestens 3·10⁻⁵ T aufweist.

Erfindungsgemäß ist also der für die Polarisierung mittels DNP verwendete MW-Resonator in derselben -Bohrung des MRT-Geräts angeordnet, in der sich das zu untersuchende Objekt befindet, und das Kontrastmittel ist demselben statischen Magnetfeld ausgesetzt, welches für die MRT-Bildgebung verwendet wird. Das Kontrastmittel wird beim Durchfluss durch die Leitung im MW-Resonator durch DNP polarisiert und dem Lebewesen unmittelbar verabreicht. Dadurch fällt der Transport des hyperpolarisierten Kontrastmittels zwischen der Einrichtung zur Polarisierung und dem MRT-Gerät vollständig weg. Die mit dem im Stand der Technik üblichen Transport unweigerlich verbundenen Polarisationsverluste, die besonders schwerwiegend sind, wenn das hyperpolarisierte Kontrastmittel hierbei das zur Hyperpolarisierung eingesetzte hohe Magnetfeld verlassen muss, können im Rahmen der Erfindung drastisch minimiert werden, weil das hyperpolarisierte Kontrastmittel unmittelbar nach Austritt aus dem MW-Resonator verabreicht werden kann. Darüber hinaus wird kein separater Magnet für die Hyperpolarisierung benötigt, und es wird keine zeitliche Abstimmung zwischen der Hyperpolarisierung in einem Gerät und der nachfolgenden Verwendung des hyperpolarisierten Kontrastmittels in einem anderen Gerät mehr benötigt.

Die Erfindung unterscheidet sich konzeptionell von dem üblichen Stand der Technik darin, dass auf die Möglichkeit, optimale Feld- und Temperaturbedingungen für die Hyperpolarisierung bereitzustellen, bewusst verzichtet wird. Die Erfindung geht von der Annahme aus, dass die Nachteile durch die weniger vorteilhaften Bedingungen für die Hyperpolarisierung im Ergebnis dadurch ausgeglichen werden können, dass die Verluste zwischen der Hyperpolarisierung und der Verabreichung minimal gehalten werden können, da das Kontrastmittel unmittelbar nach Austritt aus dem Resonator und noch im selben statischen Feld verabreicht wird.

Allerdings ist es für den Fachmann überraschend, dass das Verfahren überhaupt praktisch umsetzbar ist. Denn der Overhauser-Effekt, der bei der DNP von Flüssigkeiten der maßgebliche Mechanismus ist, nimmt bekanntlich mit der äußeren Magnetfeldstärke ab. Da für die Hyperpolarisierung jedoch das Magnetfeld des MRT-Gerätes verwendet wird, ist diese Magnetfeldstärke vorgegeben, und sie beträgt bei modernen MRTs in der Regel mindestens 1,5 T. Unter Fachleuten wurde gemeinhin angenommen, dass bei derart starken statischen Magnetfeldern eine DNP in Flüssigkeit bereits sehr ineffizient ist und insbesondere nicht für die Zwecke der Erfindung ausreichen könnte (s. auch Hausser, K. H., Stehlik, D., Dynamic Nuclear Polarization in Liquids, Advances in Magnetic Resonance (1968)). Auch die US 2009/0121712 A1 geht davon aus, dass für den Einsatz der DNP von Flüssigkeiten bei einem Magnetfeld von 1,5 T anstelle von dem darin verwendeten Feld von 0,35 T eine Reduktion der Effizienz um einen Faktor 4 bis 5 zu erwarten ist.

Ferner macht die Polarisierung von Elektronenspins im Zuge der DNP eine Mikrowellenanregung mit einer Frequenz von 40 GHz oder mehr erforderlich. Ein Mikrowellenresonator für derart hohe Frequenzen, der zur Durchleitung einer Flüssigkeit geeignet wäre, ist den Erfindern nicht bekannt, und es ist keinesfalls offensichtlich, dass ein solcher Resonator trotz Flüssigkeitsleitung im Hohlraum überhaupt mit ausreichender Güte herstellbar ist. Ein weiteres Problem stellt die Verweilzeit der Flüssigkeit im Resonator dar. Bei einer zu langen Verweilzeit besteht die Gefahr, dass das flüssige Kontrastmittel sich übermäßig erhitzt, bei einer zu geringen Verweilzeit ist zu erwarten, dass die Polarisierung, die mittels DNP im verhältnismäßig starken Magnetfeld erreichbar ist, für die Zwecke als Kontrastmittel nicht ausreicht.

Die Erfinder haben jedoch festgestellt, dass es trotz dieser auf den ersten Blick ungünstigen Ausgangslage in der Tat möglich ist, ein flüssiges Kontrastmittel selbst in einem statischen Magnetfeld von 1,5 T im Durchfluss mittels DNP zu hyperpolarisieren. Erfindungsgemäß wird die Leitung entlang einer Längsachse des Resonators angeordnet. Dadurch kann die Weglänge im Resonator erhöht werden, und die Verweilzeit wird bei gegebener Flussrate, die für eine bestimmte Anwendung benötigt wird, entsprechend verlängert. Gleichzeitig werden die Geometrie des Resonators, die Mittel zum Einkoppeln der Mikrowellen in den MW-Resonator, der Querschnitt der Leitung, die Leistung und die Frequenz der Mikrowelle so aufeinander abgestimmt, dass sich in dem MW-Resonator eine MW-Mode ausbildet, die entlang zumindest eines überwiegenden Teils der Längsachse des Resonators einen Bauch in der Magnetfeldstärke und einen Knoten in der elektrischen Feldstärke aufweist. Dies hat zur Folge, dass das flüssige Kontrastmittel vornehmlich durch Bereiche fließt, in denen die elektrische Feldstärke gering oder sogar Null ist, wodurch eine übermäßige Erwärmung des flüssigen Kontrastmittels vermieden werden kann. Ferner sind die genannten Komponenten so aufeinander abgestimmt, dass im Bereich zumindest eines Abschnitts der Leitung eine Amplitude der MW-Magnetfeldstärke B₁ von mindestens 1·10⁻⁵ T, vorzugsweise mindestens 3·10⁻⁵ Terreicht wird. Die Erfinder konnten verifizieren, dass es unter diesen Bedingungen entgegen der Erwartung möglich ist, das Kontrastmittel im Durchfluss für die Zwecke der MRT ausreichenden Maße zu polarisieren.

Aus der US 2009/0121712 A1 sind eine Vorrichtung und ein Verfahren zum Hyperpolarisieren einer Flüssigkeit bekannt, bei denen die Flüssigkeit mittels DNP in demselben statischen Magnetfeld hyperpolarisiert wird, welches auch für die NMR verwendet wird. In der gezeigten Ausführungsform handelt es sich um ein tragbares NMR-Gerät mit einem statischen Magnetfeld von lediglich 0,35 T und einer Mikrowellenanregung im X-Band, also in einem Frequenzbereich, der weit unter demjenigen der Erfindung liegt. Aufbau und Funktion des Mikrowellenresonators sind nicht beschrieben. Die Motivation für die Polarisierung im Durchfluss aus diesem Stand der Technik liegt auch nicht in der Vermeidung eines Polarisationsverlustes zwischen Hyperpolarisierung und Applikation. Vielmehr geht es bei diesem Stand der Technik darum, die Dynamik des Fluids sichtbar zu machen, um dadurch die lokale Dynamik von Wasser an Oberflächen und im Inneren von hydratisierten Materialien wie Proteinen, Membranen oder Polymeren zu untersuchen. Um einen sichtbaren dynamischen Fluss zu erreichen wird daher eine Flussrate des hyperpolarisierten Wassers von 1,5 ml/Min. verwendet. In der Beschreibung werden Untersuchungen anhand von künstlichen Modellen beschrieben, um das Funktionsprinzip zu demonstrieren. Die eigentliche beabsichtigte Anwendung liegt jedoch in der Untersuchung lebender Zellen, insbesondere von Lipid-Doppelschichtmembranen und anderen weichen biologischen Proben. Eine Verabreichung an einen Menschen oder an ein Tier zu medizinischen oder diagnostischen Zwecken mittels MRT wird jedoch nicht erwogen.

Für die DNP ist es erforderlich, dass in dem Kontrastmittel paramagnetische Substanzen vorhanden sind, die im Folgenden auch als paramagnetische Zentren bezeichnet werden. In einer bevorzugten Ausführungsform sind die paramagnetischen Zentren in dem Kontrastmittel gelöst. Zusätzlich oder alternativ können die paramagnetischen Zentren jedoch auch immobilisiert sein, beispielsweise fest an einem Gel, beispielsweise einem Agarose- oder Silica-Gel gebunden sein. Als paramagnetische Zentren können beispielsweise stabile Radikale, insbesondere TEMPOL und dessen Derivate, Trityl, Kaliumnitrosodisulfonat, paramagnetische Übergangsmetallionen, durch ionisierte Strahlung erzeugte Radikale und Moleküle im Triplett-Zustand dienen.

Vorzugsweise umfasst die Einrichtung zur Hyperpolarisation und Verabreichung eines flüssigen NMR-Kontrastmittels eine erste Leitung, die geeignet ist, das Kontrastmittel von einem Reservoir außerhalb einer Bohrung des MRT zu dem Resonator zu leiten, wenn dieser in der Bohrung des MRT angeordnet ist, und/oder eine zweite Leitung, die geeignet ist, das hyperpolarisierte Kontrastmittel von dem Resonator zum zu untersuchenden Lebewesen zu leiten, wenn sich dieses ebenfalls in der Bohrung des MRT befindet.

Vorzugsweise ist dabei der Querschnitt der zweiten Leitung geringer als derjenige der Leitung im MW-Resonator. Dies hat zur Folge, dass die Flussgeschwindigkeit in der zweiten Leitung, d. h. zwischen dem MW-Resonator und dem Patienten höher ist als im Resonator. Dadurch lässt sich bei der vorgegebenen benötigten Dosis des Kontrastmittels pro Zeit eine höhere Verweildauer im Resonator mit einem verkürzten Transport zwischen Resonator und Lebewesen vereinbaren.

Vorzugsweise weist der MW-Resonator Abschnitte auf, die zum Einstellen der Resonanzfrequenz relativ zueinander verstellbar sind, und Mittel zum Verstellen der Resonatorabschnitte relativ zueinander, die vorzugsweise von außerhalb der Bohrung des MRT zugänglich sind, wenn der MW-Resonator in dieser angeordnet ist. Dadurch lässt sich der MW-Resonator leicht auf die MW-Frequenz stimmen, die das beste DNP-Resultat erzielt. Man beachte, dass die Spin-Anregungsfrequenz von der verwendeten paramagnetischen Substanz abhängig ist. Ein derartig stimmbarer MW-Resonator bietet sich daher selbst für kommerzielle Anwendungen in der Krankenhausumgebung an, in der im Routinebetrieb keine Modifikationen an der Apparatur vorgenommen werden, weil der MW-Resonator dann vielfältiger einsetzbar wird.

In einer möglichen Ausgestaltung ist der MW-Resonator so ausgebildet, dass die eingestrahlte MW-Frequenz einer Grundschwingung des Resonators entspricht. In einer vorteilhaften Weiterbildung sind die Abmessungen des MW-Resonators jedoch derart auf eine von der MW-Quelle erzeugbare Frequenz abgestimmt, dass diese Frequenz einer MW-Mode im Resonator entspricht, die bezüglich der Längsachse des Resonators eine Oberschwingung darstellt. Dies bedeutet, dass die Ausdehnung des MW-Resonators entlang der Längsachse - bei vorgegebener MW-Frequenz - ein Vielfaches der Länge betragen kann, die sich für einen Betrieb in der Grundschwingung ergeben würde. Dies ermöglicht eine Verlängerung des Resonators entlang der Längsachse, wodurch die Wegstrecke des Kontrastmittels innerhalb des Resonators verlängert werden kann, was wiederum bei einer vorgegebenen Dosisrate und einem vorgegebenem Querschnitt der Leitung im Resonator eine entsprechende Verlängerung der Verweilzeit im MW-Resonator erlaubt. Ferner haben die Erfinder festgestellt, dass sich hierdurch auch die Güte des MW-Resonators steigern lässt. Man beachte, dass es in dem hier vorliegenden sehr kurzwelligen Mikrowellenbereich nicht ohne weiteres möglich ist, den Querschnitt der Leitung beliebig zu wählen, weil ein zu großer Querschnitt die Güte des MW-Resonators senkt. Es ist also nicht möglich, für eine bestimmte erwünschte Dosisrate für die Applikation des NMR-Kontrastmittels beliebig hohe Verweilzeiten des Kontrastmittels im Resonator dadurch zu erreichen, dass der Querschnitt der Leitung im Resonator entsprechend vergrößert wird. Aus diesem Grund ist es von Vorteil, auf die genannte Weise die Länge des Resonators entlang der Längsachse zu vergrößern.

Vorzugsweise ist der MW-Resonator an seiner dem MW-Feld zugewandten Oberfläche elektrisch leitend. Insbesondere kann der MW-Resonator zumindest teilweise aus einem Trägermaterial bestehen, welches an seiner dem MW-Feld zugewandten Oberfläche mit einer gut leitenden Schicht, insbesondere einer Silberschicht überzogen ist. Man beachte, dass bei den hier vorliegenden Mikrowellenfrequenzen im hohen GHz-Bereich erhebliche Anforderungen an die Präzision des Resonators gestellt werden, die nicht mit den weitaus geringeren Anforderungen beispielsweise bei X-Band-Resonatoren vergleichbar sind. Bei dem vorgeschlagenen Aufbau mit einem beschichteten Trägermaterial ist es möglich, ein Trägermaterial zu verwenden, das sich ausreichend gut bearbeiten lässt, ohne bei der Wahl auf besonders gut leitfähige Materialien beschränkt zu sein. Die Dicke der leitenden Schicht sollte einige Skintiefen betragen. Vorzugsweise ist sie mindestens 0,5 µm, besonders vorzugsweise 1 µm und insbesondere mindestens 2 µm dick.

Bevorzugte Trägermaterialien werden durch Bronze-, Messing- oder Rotgusslegierungen, Aluminium, Kupfer oder Neusilber gebildet. Die genannten Legierungen sind vorzugsweise ausgeglüht, um die erforderliche geometrische Präzision zu gewährleisten. Eine besonders vorteilhafte Ausführungsform verwendet einen wasserstofffreien Kunststoff als Trägermaterial, der den Vorteil hat, kein NMR-Hintergrundsignal zu erzeugen. Bevorzugte Kunststoffe hierfür sind PCTFE, Vespel oder PTFE.

Wie oben erwähnt wurde, sind der erreichbaren Dosisrate durch die Beschränkung der Größe des Resonators, den begrenzten Querschnitt der Leitung und die erforderliche Verweilzeit des Kontrastmittels im Resonator Grenzen gesetzt. In einer vorteilhaften Weiterbildung wird daher eine Mehrzahl von Resonatoren der eingangs genannten Art verwendet, die parallel von Kontrastmittel durchflossen werden. Auf diese Weise können die einzelnen Resonatoren im Hinblick auf ihre Funktion unabhängig von der Flussrate optimiert werden und eine erwünschte Flussrate durch eine entsprechende Anzahl Resonatoren erreicht werden. Vorzugsweise ist eine Einrichtung zum Temperieren, insbesondere Erwärmen des Kontrastmittels vorgesehen, die in Flussrichtung des Kontrastmittels betrachtet vor dem MW-Resonator angeordnet ist. Zusätzlich oder alternativ kann auch eine Einrichtung zum Temperieren, insbesondere Erwärmen des Kontrastmittels, direkt hinter dem MW-Resonator angeordnet sein. Durch diese Einrichtungen kann sichergestellt werden, dass die Temperatur des Kontrastmittels vor dem Resonator für die Polarisation und nach dem Resonator für den Transfer optimal eingestellt wird, da durch eine erhöhte Temperatur die Relaxationszeit T₁ erhöht wird. Zusätzlich dazu kann die Temperatur vor Injektion in das zu untersuchende Objekt auf einen für das zu untersuchende Objekt angepassten Wert, insbesondere auf die Körpertemperatur eines lebenden Subjektes, geregelt werden.

In einer besonders vorteilhaften Ausführungsform ist der Resonator ein Zylinderresonator. Seine Geometrie ist vorzugsweise so auf die Frequenz der MW-Quelle abgestimmt, dass die Frequenz einer TE₀₁₁- oder eine TE₀₁₂-Mode im Resonator entspricht.

Vorzugsweise weist der MW-Resonator einen zylindrischen Resonatorabschnitt auf, der an wenigstens einem Längsende durch einen entlang der Längsachse des Resonators verstellbaren Kolben oder Stempel begrenzt wird. Dadurch kann der Resonator leicht auf eine erwünschte Resonanzfrequenz abgestimmt werden.

Bei den vorliegenden hohen MW-Frequenzen von über 40 GHz muss der Resonator jedoch mit höchster Präzision gestimmt werden. In einer vorteilhaften Weiterbildung weist der mindestens eine verstellbare Kolben oder Stempel daher ein Außengewinde auf, welches mit einem am Resonator vorgesehenen Innengewinde in Eingriff ist, derart, dass der Kolben bzw. Stempel durch Drehung um seine Achse in Richtung parallel zur Längsachse des MW-Resonators verstellbar ist. In einer vorteilhaften Weiterbildung kann der Kolben durch ein Schneckengetriebe zu seiner Verstellung gedreht werden.

Vorzugsweise hat der Zylinderresonator einen Innendurchmesser von 8,4 - 15 mm, besonders vorzugsweise 8,7 - 11 mm und besonders vorzugsweise von 9,0 - 9,4 mm. Wird der Durchmesser zu groß gewählt, kann eine Mehrzahl von unerwünschten Moden im Resonator entstehen.

In einer vorteilhaften Weiterbildung ist der Zylinderresonator in seiner Länge zwischen 11,0 und 12,0 mm (für die TE₀₁₁-Mode) oder zwischen 22,0 und 24,0 mm (für die Mode TE₀₁₂) verstellbar. Durch diese Verstellbarkeit können für unterschiedliche Radikale die passenden Resonanzfrequenzen eingestellt werden. Falls noch höhere Moden angeregt werden sollen, kann der oben genannte Längenbereich entsprechend vervielfacht werden.

Vorzugsweise ist eine Iris zum Einkoppeln der elektrischen Feldkomponente der Mikrowelle in den MW-Resonator vorgesehen. Die Wahl der Iris hat einen entscheidenden Einfluss auf den sogenannten Conversion Factor des Resonators. Vorzugsweise ist die Iris eine Schlitziris, die vorzugsweise eine Schlitzbreite von 0,01 - 1 mm, besonders vorzugsweise von 0,2 - 0,4 mm und/oder eine Länge von 1 - 10 mm, vorzugsweise 5 - 7 mm hat. In einer vorteilhaften Weiterbildung ist die Iris größenverstellbar. Dies hat den Vorteil, dass sie im Betrieb optimal an den Resonator und die Leitung angepasst werden kann, was bei den hier vorliegenden hohen Mikrowellenfrequenzen ebenfalls wesentlich delikater ist als beispielsweise bei Mikrowellen im X-Band.

Alternativ ist es jedoch auch möglich, Mittel zum Einkoppeln der magnetischen Feldkomponente der Mikrowelle in den Resonator vorzusehen.

### BESCHREIBUNG DES BEVORZUGTEN AUSFÜHRUNGSBEISPIELS

Weitere Vorteile und Merkmale der Erfindung ergeben sich aus der folgenden Beschreibung, in der das Verfahren zum Verabreichen eines hyperpolarisierten flüssigen Kontrastmittels und eine zugehörige Einrichtung anhand eines bevorzugten Ausführungsbeispiels unter Bezugnahme auf die beigefügten Zeichnungen erläutert werden. Darin zeigen:
- Fig. 1: eine schematische Darstellung eines MRT-Gerätes, in dessen Bohrung sich ein zu untersuchendes Tier und eine Einrichtung zur Polarisation eines flüssigen NMR-Kontrastmittels befinden,
- Fig. 2: ein Blockdiagramm von wesentlichen Komponenten der Einrichtung von Fig. 1,
- Fig. 3: drei Schnittansichten eines Zylinderresonators zur Verwendung in der Einrichtung von Fig. 1 und 2,
- Fig. 4: NMR-Spektren, die bei stehendem Kontrastmittel im Resonator von Fig. 3 mit und ohne Mikrowelleneinstrahlung aufgenommen wurden,
- Fig. 5: NMR-Spektren, die bei fließendem Konstrastmittel mit und ohne MW-Einstrahlung aufgezeichnet wurden,
- Fig. 6: die Verstärkung des NMR-Signals in Abhängigkeit von der Flußrate des Kontrastmittels,
- Fig. 7a, b: MRI-Bilder einer von Kontrastmittel durchflossenen Kapillare mit und ohne DNP, und
- Fig. 8, 9: MRI-Bilder von einer flachen Zelle, die von Kontrastmittel durchflossen ist.

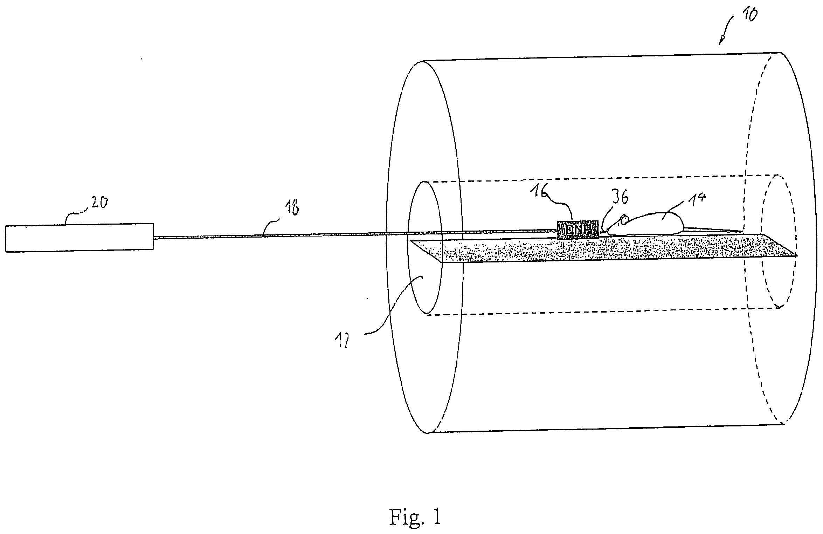

In Fig. 1 ist ein Magnet 10 eines MRT-Geräts schematisch dargestellt. Der Magnet 10 hat eine Bohrung 12, in der ein statisches Magnetfeld mit einer Stärke von 1,49552 T erzeugt wird. Ferner sind in dem MRT-Gerät wie üblich Mittel zum Erzeugen eines Hochfrequenzfeldes für die resonante Anregung von Kernspins sowie Mittel zum Erzeugen eines magnetischen Gradientenfeldes für die Bildgebung vorgesehen, die in der Figur jedoch nicht gezeigt sind.

Wie weiter in Fig. 1 zu sehen ist, befindet sich in der Bohrung 12 des Magneten 10 ein zu untersuchendes Lebewesen 14, im gezeigten Beispiel eine Maus. Die Einrichtung und das Verfahren der Erfindung sind jedoch ebenso und ganz besonders für Anwendungen in der Humanmedizin verwendbar.

Weiter befindet sich in der Bohrung 12 des Magneten 10 ein MW-Resonator 16, der über einen Wellenleiter 18 mit einer Mikrowellenquelle 20 verbunden ist. Im gezeigten Ausführungsbeispiel ist die Mikrowellenquelle 20 geeignet, Mikrowellen mit Frequenzen in einem Bereich von 41 GHz bis 43 GHz zu erzeugen. Der MW-Resonator 16 ist dazu bestimmt, ein durch diesen hindurchfließendes NMR-Kontrastmittel mittels DNP zu polarisieren. Die Zuleitung des Kontrastmittels ist in Fig. 1 nicht gezeigt.

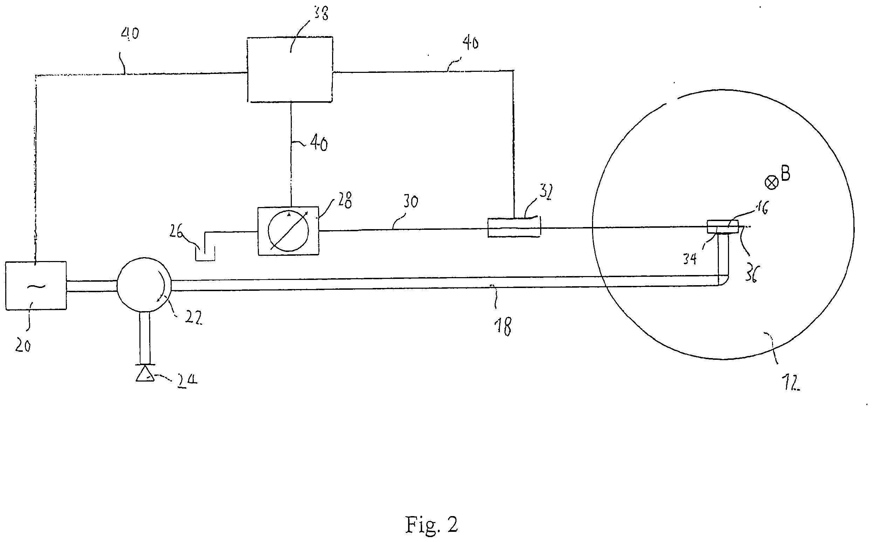

Fig. 2 zeigt ein Blockdiagramm von weiteren Komponenten der Einrichtung zur Hyperpolarisation des flüssigen NMR-Kontrastmittels. In Fig. 2 sind ebenfalls wie in Fig. 1 die Bohrung 12 des Magneten 10, die Mikrowellenquelle 20 und der Wellenleiter 18 schematisch dargestellt. Ferner sind ein MW-Zirkulator 22 und eine Empfängerdiode 24 dargestellt, die dem Auffinden der Resonanzlinien und dem Einstellen der Resonanzfrequenz des Resonators dient.

Außerdem ist in Fig. 2 ein Reservoir 26 für eine hyperpolarisierbare Flüssigkeit gezeigt, die in der vorliegenden Beschreibung der Einfachheit halber als "NMR-Kontrastmittel" - in Anlehnung an die Terminologie aus der Röntgendiagnostik - bezeichnet wird. Die Funktion des hyperpolarisierten Kontrastmittel besteht darin, dass die NMR-Signale durch dessen Polarisierungsgrad, der weit über dem Polarisierungsgrad gemäß der Boltzmann-Verteilung unter den gegebenen Bedingungen liegt, verstärkt werden. Es versteht sich, dass die Flüssigkeit streng genommen erst nach der Hyperpolarisierung zu einem Kontrastmittel wird, jedoch wird in der vorliegenden Beschreibung der Einfachheit halber sowohl die unpolarisierte als auch die hyperpolarisierte Flüssigkeit als NMR-Kontrastmittel bezeichnet.

Weiter ist in Fig. 2 eine Pumpe 28 gezeigt, die geeignet ist, das NMR-Kontrastmittel kontinuierlich aus dem Reservoir 26 durch eine erste Leitung 30 zum MW-Resonator 16 in der Bohrung 12 zu leiten. Im Flussweg des NMR-Kontrastmittels entlang der ersten Leitung 30 ist eine Einrichtung 32 zum Temperieren desselben vorgesehen. Durch eine derartige Einrichtung 32 kann das flüssige Kontrastmittel beispielsweise so weit abgekühlt werden, dass es nach der unvermeidlichen Erwärmung im MW-Resonator 16 nahe an der Körpertemperatur des Lebewesens 14 liegt. Obwohl dies in Fig. 2 nicht gezeigt ist, kann auch eine weitere Einrichtung zum Temperieren zwischen den Resonator 16 und dem Lebewesen 14 vorgesehen sein.

In dem MW-Resonator 16 fließt das Kontrastmittel dann durch eine Leitung 34, die unten im Detail beschrieben wird. Stromabwärts des MW-Resonators 16 befindet sich eine zweite Leitung 36, die zum Lebewesen 14 führt (in Fig. 2 nicht vollständig gezeigt). In dem bevorzugten Ausführungsbeispiel ist der Querschnitt der zweiten Leitung 36 geringer als derjenige der Leitung 34 im MW-Resonator 16, sodass bei gleicher Flussrate die Flussgeschwindigkeit erhöht, also die Fließzeit zwischen dem MW-Resonator 34 und dem Lebewesen 14 verringert wird, um die Verluste in der Polarisierung möglichst gering zu halten.

Schließlich ist in Fig. 2 eine Steuereinrichtung 38 vorgesehen, die zur Steuerung der Mikrowellenquelle 20, der Pumpe 28 und der Einrichtung zum Temperieren 32 mit diesen über Steuerleitungen 40 verbunden ist.

Als nächstes wird die Funktion der Einrichtung von Fig. 1 und 2 erläutert. Eine Besonderheit der Einrichtung von Fig. 1 und 2 besteht darin, dass das NMR-Kontrastmittel mittels DNP im selben Magnetfeld polarisiert wird, in dem die MRT durchgeführt wird und dass die Hyperpolarisierung zumindest phasenweise kontinuierlich mit der Verabreichung an das Lebewesen 14 geschieht. Dadurch kann der im Stand der Technik übliche Transport des hyperpolarisierten Kontrastmittels von einer Einrichtung zur Hyperpolarisierung zum MRT-Gerät entfallen. Dies hat zum einen Vorteile hinsichtlich der Handhabung und der Verfahrensökonomie. Ein weiterer wichtiger Vorteil besteht darin, dass das Kontrastmittel unmittelbar nach seiner Hyperpolarisierung verabreicht wird, sodass zwischen Hyperpolarisierung und Verabreichung vergleichsweise geringe Polarisationsverluste auftreten. Diese Polarisationsverluste sind ein wesentliches Problem bei dem Stand der Technik, bei dem das Kontrastmittel zwischen Hyperpolarisierung und Verabreichung transportiert und oftmals noch aufgetaut werden muss.

Die Hyperpolarisierung erfolgt im MW-Resonator 16, während das Kontrastmittel in der Leitung 34 durch diesen hindurchgeführt wird. Das Kontrastmittel hat Atomkerne mit Kernspins, die im Magnetfeld ausgerichtet werden können. Im einfachsten Fall kann es sich dabei um die Wasserstoffkerne in Wasser handeln, aber auch andere Kerne, wie z. B. ¹³C sind einsetzbar. Weitere wichtige Kontrastmittel sind beispielsweise Pyruvat und Lactat, welches als Stoffwechselmarker eingesetzt werden kann. Ferner müssen zur Hyperpolarisierung mittels DNP paramagnetische Zentren bzw. ungepaarte Elektronen vorhanden sein. Diese können durch stabile Radikale wie beispielsweise TEMPOL oder dessen Derivate, Fremy's-Salz oder Ähnliches gebildet sein, durch paramagnetische Übergangsmetallionen in Lösung oder im Festkörper. Weitere Beispiele für paramagnetische Zentren sind Moleküle im Triplett-Zustand oder durch Ionisierung erzeugte Radikale in Kristallen. Die Radikale können in dem Kontrastmittel selbst gelöst und/oder an ein Molekül, insbesondere ein Targetmolekül gebunden sein. Alternativ können die paramagnetischen Zentren jedoch auch immobilisiert sein, beispielsweise an ein Gel gebunden sein, dass in der Leitung 34 im MW-Resonator 16 angeordnet ist. Es ist auch möglich, die Radikale bzw. ihre Träger vor der Verabreichung aus der Lösung abzutrennen.

In Abhängigkeit von der Anwendung und dem verwendeten NMR-Kontrastmittel können unterschiedliche Verweilzeiten des Kontrastmittels im MW-Resonator 16 vorteilhaft sein. Bevorzugte Verweilzeiten betragen zwischen einigen Sekunden und 100 Millisekunden. Die Flussgeschwindigkeit wird vorzugsweise so gewählt, dass am Bildgebungsziel eine maximale Polarisation erreicht wird. Diese ist abhängig von der Geometrie des Flusssystems und der Geschwindigkeit des Polarisationsaufbaus, der seinerseits von den verwendeten Radikalen bzw. deren Konzentration abhängig ist. Die erreichte Polarisation ist zu einem gewissen Grade auch leistungsabhängig. Die richtige Wahl der Flussgeschwindigkeit hängt auch von der Relaxationsgeschwindigkeit der hyperpolarisierten Kerne ab. Bevorzugte Flussgeschwindigkeiten liegen zwischen 1 mm/s bis 1 m/s, was bei der im Ausführungsbeispiel verwendeten Leitung einem Fluss von 1,8 ml/h bis 1800 ml/h entspricht. Bevorzugte Durchflussraten liegen bei 6 bis 12 ml/h.

Es ist von Vorteil, wenn die Flussgeschwindigkeit und Verweilzeit in Hinblick auf das Polarisationsergebnis optimiert werden können und nicht zusätzlich noch in Hinblick auf eine erwünschte Dosisrate für die Verabreichung beschränkt ist. Dies gilt insbesondere für den Fall, bei dem höhere Dosisraten benötigt werden, die nicht ohne weiteres durch größere Querschnitte der Leitung 34 erreicht werden können, weil ein größerer Leitungsdurchmesser die Güte des Mikrowellenresonators 16 verschlechtert. Stattdessen kann es vorteilhaft sein, mehrere Resonatoren mit Leitungen geringeren Querschnitts parallel zu betreiben (nicht gezeigt).

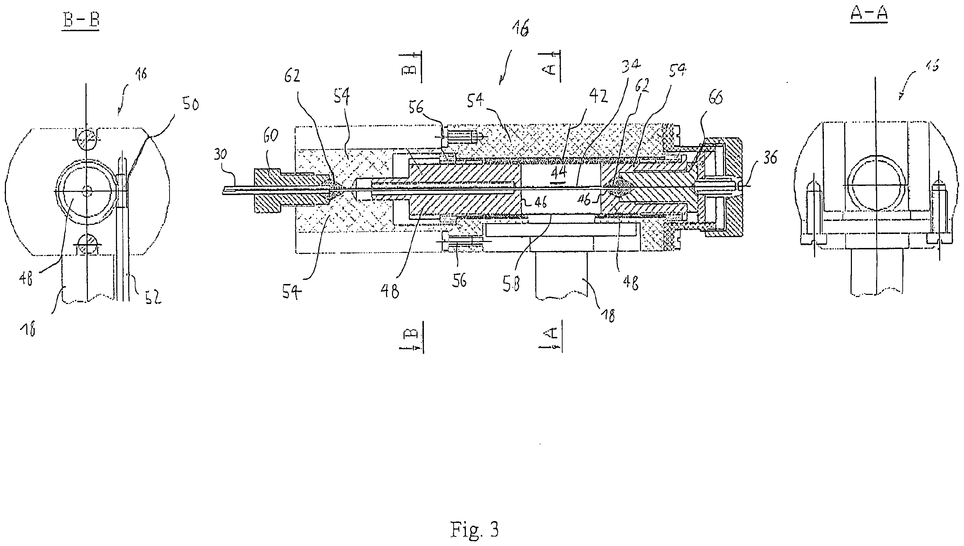

In Fig. 3 ist ein Beispiel für den MW-Resonator 16 gezeigt, bei dem es sich um einen Zylinderresonator handelt.

Der Zylinderresonator umfasst einen Rotguss-Zylinder 42, der an seiner Innenseite mit einer Silberschicht überzogen ist, um die Leitfähigkeit an der Resonator-Innenwand zu erhöhen. Die leitfähige Schicht sollte einige Skintiefen der Mikrowellen dick sein. Im vorliegenden Beispiel beträgt die Skintiefe der Mikrowellen einige 100 nm, und die Silberschicht ist 2 µm dick. Im Inneren des Rotguss-Zylinders 42 ist ein zylindrischer Resonatorhohlraum 44 ausgebildet.

Der Resonatorhohlraum 44 wird an den Endflächen des Zylinders durch Stirnflächen 46 von Messingkolben 48 begrenzt, die an ihren Stirnflächen 46 ebenfalls mit Silber überzogen sind. Der linke Messingkolben 48 ist entlang der Längsachse des Zylinderhohlraums 44 verstellbar. Dazu ist an seiner Außenfläche ein Außengewinde ausgebildet, welches mit einem Innengewinde im Rotguss-Zylinder 42 in Eingriff steht. Durch Drehung des Kolbens 48 kann also die axiale Länge des zylindrischen Resonatorhohlraums 44 präzise eingestellt werden. Wie in der Schnittansicht B-B gezeigt ist, kann der Kolben 48 zu seiner Verstellung über eine Schraube 50 gedreht werden, die mit einem Gewinde (nicht gezeigt) am Außenumfang des Kolbens 48 in Eingriff steht und diesen nach Art eines Schneckengetriebes antreibt. Die Schraube 50 hat einen verlängerten Schaft 52, über den sie von außerhalb der Bohrung 12 des MRT-Magneten benutzbar ist. Dadurch lässt sich der MW-Resonator 16 in der Bohrung 12 abstimmen.

Der MW-Resonator 16 hat eine mehrteilige Halterung aus einem wasserstofffreien Kunststoff, im gezeigten Ausführungsbeispiels aus Vespel. Die einzelnen Abschnitte 54 der Halterung sind mit Schrauben 56 verschraubt.

Wie weiter in Fig. 3 zu erkennen ist, wird die Mikrowelle über den Wellenleiter 18 und eine Schlitziris 58 in den Resonatorhohlraum 44 eingekoppelt. Die Schlitziris 58 hat im gezeigten Ausführungsbeispiel eine Länge von 5,5 mm und ist daher etwas kürzer als der Durchmesser des Wellenleiters, der 5,6 mm beträgt. Die Breite der Iris beträgt zwischen 0,01 und 1 mm, im konkreten Ausführungsbeispiel 0,29 mm. Die Erfinder haben festgestellt, dass bei der Ausbildung der Iris in Hinblick auf eine effiziente Einkopplung eine Präzision erforderlich, die wesentlich höher ist, als diejenige, die man bei längeren Wellenlängen, beispielsweise im X-Band benötigt. Es hat sich als vorteilhaft herausgestellt, die Iris 58 im Erosionsverfahren herzustellen, um die benötigte Präzision zu gewährleisten.

Schließlich ist in Fig. 3 die Leitung 34 zu erkennen, die in Dichtungskolben 60 mit der ersten bzw. zweiten Leitung 30, 36 verbunden ist. Zur Abdichtung der Übergänge zwischen den Abschnitten der Leitung ist eine Teflondichtung 62 vorgesehen, die komprimiert wird, wenn die Dichtungskolben 60 an der Halterung 54 (in Fig. 3 links) bzw. dem Kolben 48 (in Fig. 3 rechts) festgeschraubt ist.

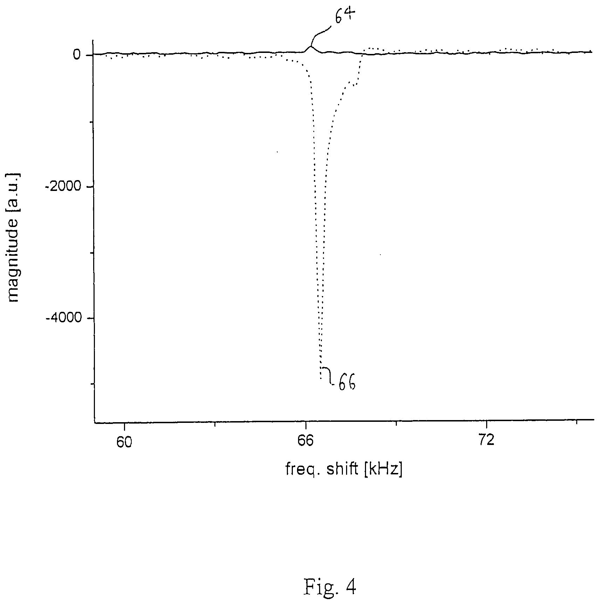

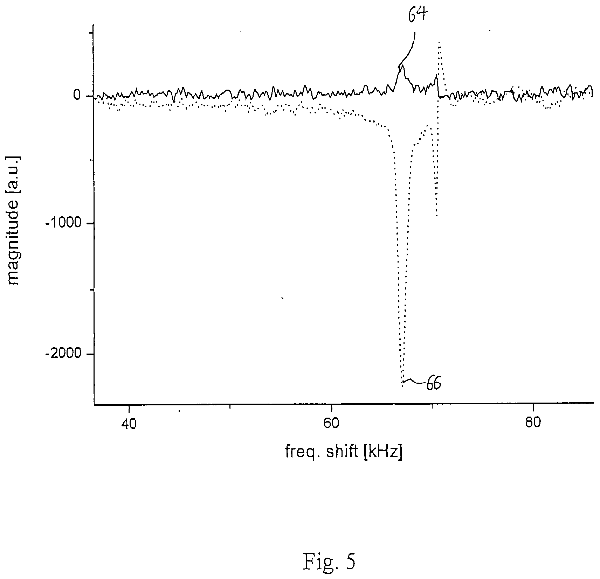

In Fig. 4 und 5 sind NMR-Spektren eines Protonensignals in Wasser bei einer Frequenzverschiebung von ca. 66 kHz gezeigt, die unter Verwendung des Resonators 16 von Fig. 3 erzeugt wurden. Die durchgezogene Linie zeigt jeweils den Vergleichsfall, in dem keine Mikrowellen in den Resonator 16 eingestrahlt wurden und die gestrichelte Linie jeweils den Fall mit einer MW-Einstrahlung von 2 W. Fig. 4 zeigt die NMR-Signale für den Fall, dass das Kontrastmittel in der Leitung 34 im Resonator 16 steht und Fig. 5 den Fall, dass das Kontrastmittel durch den Resonator 16 mit einer Durchflussrate von 8 ml/h fließt. Als Kontrastmittel wurde hier Wasser mit 12 mMol/l TEMPOL verwendet.

In Fig. 4 ist zu erkennen, dass sich bei einem stehenden Kontrastmittel das normale NMR-Signal 64 in Folge der Hyperpolarisierung durch DNP um einen Faktor von -98 steigern lässt (vgl. Signal 66). Dies ist ein außerordentliches und überraschendes Ergebnis, das bei so hohen Magnetfeldstärken und entsprechend hoher Mikrowellenfrequenz für ein flüssiges Kontrastmittel nicht vorhersehbar war. Aus Fig. 5 ist zu entnehmen, dass sich selbst im Durchfluss des Kontrastmittels ein Verstärkungsfaktor von -14 in Folge der Hyperpolarisierung ergibt. Dies weist darauf hin, dass das erfindungsgemäße Verfahren und die erfindungsgemäße Einrichtung zur Hyperpolarisierung in der Tat sehr gut zur Erhöhung der NMR-Empfindlichkeit geeignet sind, und insbesondere in der MRT erhebliche Verbesserungen gegenüber dem Stand der Technik versprechen.

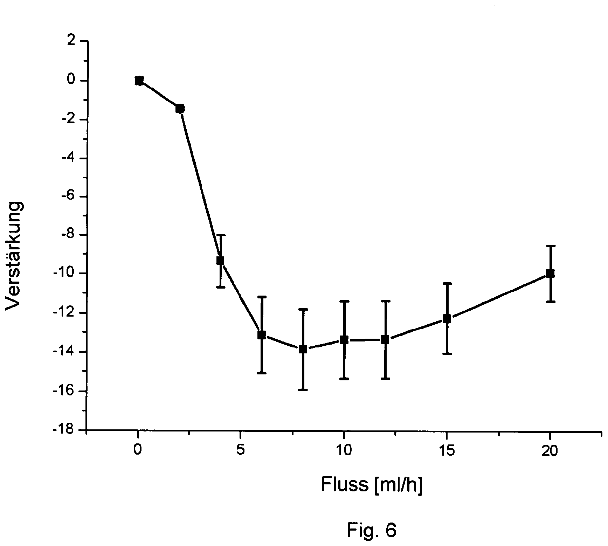

Für die Frage, wie stark die Hyperpolarisierung des Kontrastmittels im zu untersuchenden Objekt ist, ist die Flußgeschwindigkeit des Kontrastmittels durch den Mikrowellenresonator von Bedeutung. Einerseits führt eine geringere Flußrate zu einer größeren Verweilzeit im Resonator und dadurch zu einer stärkeren Hyperpolarisierung. Andererseits beträgt die Flußzeit zwischen dem MW-Resonator und dem zu untersuchenden Objekt umso länger, je geringer die Flußrate ist. Während des Transfers zwischen dem MW-Resonator und dem zu untersuchenden Objekt wird ein Teil der hyperpolarisierten Kernspins in den thermischen Gleichgewichtszustand relaxieren, wodurch die Hyperpolarisierung als Ganzes abnimmt. Insofern muss in der Praxis ein Kompromiß zwischen kurzen Transferzeiten zwischen MW-Resonator und zu untersuchendem Objekt (d. h. hohen Flußgeschwindigkeiten) und ausreichenden Verweilzeiten im MW-Resonator (d. h. niedrigen Flußgeschwindigkeiten) gefunden werden. Dieser Kompromiß kann experimentell ermittelt werden. Beispielsweise zeigt Fig. 6 die Verstärkung des NMR-Signals in Abhängigkeit von der Flußrate. Wie darin zu sehen ist, ist bei der vorliegenden Geometrie die Verstärkung betragsmäßig am größten, wenn die Flußrate zwischen 6 und 12 ml/h beträgt. Der beschriebene Kompromiß kann teilweise dadurch aufgelöst werden, dass der Querschnitt der Leitung, durch die das Kontrastmittel zwischen dem MW-Resonator und dem zu untersuchenden Objekt geführt wird, geringer ist als der Querschnitt der Leitung innerhalb des MW-Resonators, wodurch das Kontrastmittel während des Transfers vom MW-Resonator zum Objekt schneller fließt als innerhalb des MW-Resonators.

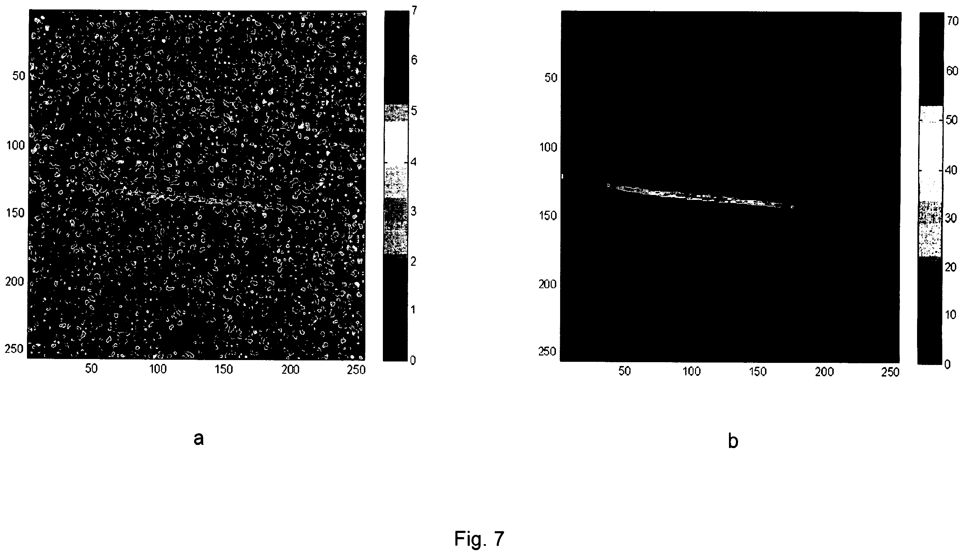

Fig. 7 zeigt Ergebnisse einer Testanwendung der Einrichtung der Erfindung. Darin wurde das Kontrastmittel nach Ausstritt aus dem MW-Resonator durch eine Glaskapillare mit einem Durchmesser von 0,15 mm geleitet. Eine solche Kapillare ist von ähnlicher Größe wie ein kleines Blutgefäß. Fig. 7a zeigt das MRI-Bild ohne DNP, das heißt für den Fall, dass der MW-Resonator nicht aktiv ist. Im Falle von Fig. 7a wurden acht Scans benötigt, um den Innenraum der Kapillare überhaupt sichtbar zu machen.

Fig. 7b zeigt den Fall, in dem der MW-Resonator eingeschaltet und das Kontrastmittel mittels DNP hyperpolarisiert wurde. Wie Fig. 7b zu entnehmen ist, kann die Kapillare in einem einzigen MRI-Scan sichtbar gemacht werden. In beiden Bildern erkennt man die Empfindlichkeitsverteilung der Abbildungsspule, da das Signal auf der Längenskala der Abbildungsspule, im gezeigten Fall etwa 20 mm, abfällt.

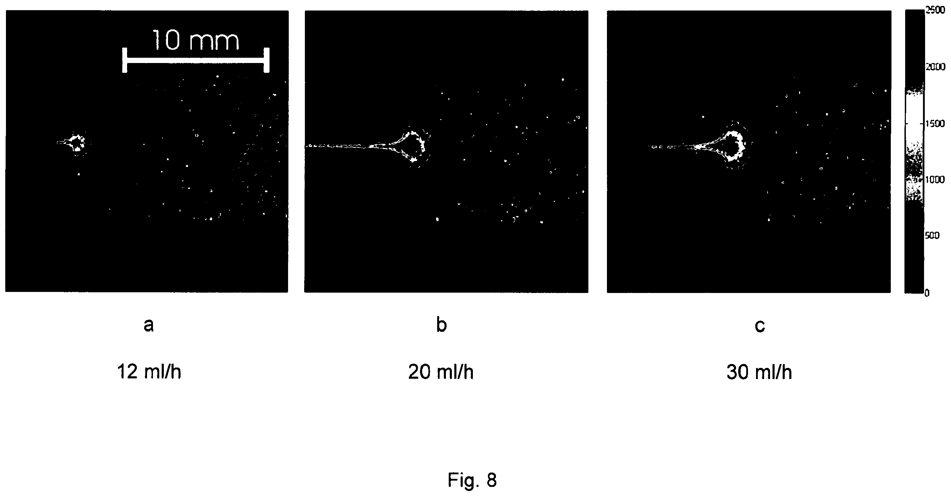

Fig. 8 zeigt eine Beispielmessung, bei der das hyperpolarisierte Kontrastmittel durch eine flache Zelle geleitet wird, in der sich eine Probe bei thermischer Polarisierung befindet. Fig. 8a zeigt die NMR-Signale bei einer Flußrate von 12 ml/h, Fig. 8b bei einer Flußrate von 20 ml/h und Fig. 8c bei 30 ml/h. In allen Fällen ist die Dispersion und das Abklingen der Hyperpolarisierung gut zu erkennen. Da die Zelle eine homogene Dicke hat, zeigen die Bilder von 8a-8c keine Volumeneffekte, d. h. jedes Pixel in der zweidimensionalen Abbildung repräsentiert das gleiche Volumen an Kontrastmittel. Insofern repräsentiert die gezeigte NMR-Intensität die Nettomagnetisierung des entsprechenden Voxels. Aus dem Vergleich von Fig. 8b und 8c ist deutlich, dass eine größere Flußgeschwindigkeit zu einem größeren hyperpolarisierten Strahl führt, gleichzeitig führt jedoch die geringere Flußrate in Fig. 8b zu einer erhöhten Signalintensität, d. h. zu einem besseren Polarisationstransfer. Dies zeigt wiederum, dass je nach Anwendung die Flußrate auf die zugrundeliegende Geometrie abgestimmt werden sollte.

Bei genauer Betrachtung von Fig. 8 fällt auf, dass die NMR-Intensität des Strahls des hyperpolarisierten Kontrastmittels unmittelbar nach Eintritt in die flache Zellen nicht so groß ist, wie etwas stromabwärts davon, wenn das Kontrastmittel etwas diffundiert und verlangsamt ist. Der Grund hierfür ist die relative hohe Geschwindigkeit, mit der das hyperpolarisierte Kontrastmittel sich durch die Gradientenfelder bewegt, was zu einer Dephasierung und somit zu einem schwächeren Signal führt. Dieser Effekt wird stärker, wenn Abbildungssequenzen verwendet werden, die besonders empfindlich für diese Art der Dephasierung sind, wie beispielsweise die Spin-Echo-Sequenz. Diesen Effekt kann man ausnutzen, um das Signal für das schnell bewegte Kontrastmittel aktiv zu unterdrücken, während das Signal für das Kontrastmittel bei geringeren Geschwindigkeiten stärker ausgeprägt ist.

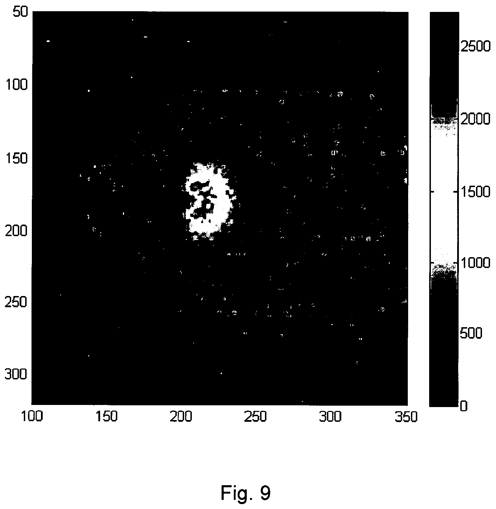

Ein Beispiel hierfür ist in Fig. 9 gezeigt, in der die Intensität in den Bereichen, in denen das Kontrastmittel sich langsam bewegt, ähnlich ist wie in Fig. 8. Die Bereiche mit hoher Strömungsgeschwindigkeit hingegen führen, trotz Hyperpolarisierung, zu einem nahezu verschwindenden Signal.

In dem gezeigten Ausführungsbeispiel wurde die Hyperpolarisierung durch die TE₀₁₁-Mode erreicht, die einen Knoten in der elektrischen Feldstärke entlang der Längsachse des Zylinderhohlraums 44, d. h. im Bereich der Leitung 34 aufweist und in diesem Bereich einen Bauch in der Magnetfeldstärke hat.

Obwohl im vorliegenden Beispiel ein Zylinderresonator verwendet wurde, ist die Erfindung nicht darauf beschränkt. Insbesondere bieten sich als Alternative zu einem geschlossenen, d. h. Hohlraumresonator wie dem gezeigten Zylinderresonator auch offene Resonatoren an, beispielsweise Fabry-Perot-Resonatoren, die aufgrund ihrer Bauart eine Dissipation der Wärme begünstigen, die im Kontrastmittel durch das Mikrowellenfeld erzeugt wird. Die Lehre der Erfindung kann daher auch auf andere Resonatortypen übertragen werden. Wesentlich ist, dass die Geometrie des Resonators, die Mittel zum Einkoppeln der Mikrowellen in den MW-Resonator, der Querschnitt der Leitung, die Leistung und die Frequenz der MW-Quelle so aufeinander abgestimmt sind, dass in dem MW-Resonator eine MW-Mode ausgebildet werden kann, die entlang zumindest eines überwiegenden Teils einer Längsachse des Resonators einen Bauch in der Magnetfeldstärke und einen Knoten in der elektrischen Feldstärke aufweist, und im Bereich zumindest eines Abschnittes der Leitung eine Amplitude des MW-Magnetfelds von mindestens 1·10⁻⁵ T, vorzugsweise von mindestens 3·10⁻⁵ T erzeugbar ist.

### BEZUGSZEICHENLISTE

- 10: MRT-Magnet
- 12: Bohrung im MRT-Magneten 10
- 14: Lebewesen
- 16: MW-Resonator
- 18: Mikrowellenleiter
- 20: Mikrowellenquelle
- 22: Zirkulator
- 24: Empfängerdiode
- 26: Reservoir für NMR-Kontrastmittel
- 28: Pumpe
- 30: erste Leitung
- 32: Einrichtung zur Temperierung
- 34: Leitung im Resonator 16
- 36: zweite Leitung
- 38: Steuereinrichtung
- 40: Steuerleitung
- 42: Rotguss-Zylinder
- 44: Zylinderhohlraum
- 46: Stirnfläche
- 48: Kolben
- 50: Schraube
- 52: verlängerter Schaft der Schraube 50
- 54: Kunststoffhalterung
- 56: Schraube
- 58: Schlitziris
- 60: Dichtungskolben
- 62: Teflondichtung
- 64: NMR-Signal ohne Hyperpolarisierung
- 66: NMR-Signal mit Hyperpolarisierung

## Patentansprüche

1. Verfahren zur Bereitstellung eines hyperpolarisierten flüssigen Kontrastmittels zur Verwendung in einem MRT-Gerät, insbesondere zur Verabreichung an ein Lebewesen (14) in einem MRT-Gerät, mit den folgenden Schritten:
Durchleiten des flüssigen Kontrastmittels durch eine Leitung (34), die sich entlang einer Längsachse eines MW-Resonators (16) erstreckt, der in dem Magnetfeld des MRT-Gerätes angeordnet ist,
Einkoppeln einer Mikrowelle mit einer Frequenz von mindestens 40 GHz in den MW-Resonator (16), die geeignet ist, das flüssige Kontrastmittel beim Durchfluss durch die Leitung (34) im MW-Resonator (16) mittels DNP zu polarisieren,
wobei das Kontrastmittel zumindest phasenweise in einem kontinuierlichen Durchfluss im MW-Resonator (16) polarisiert wird zum Zweck der unmittelbaren Verabreichung an das Lebewesen, wobei in dem MW-Resonator eine MW-Mode ausgebildet wird, die entlang zumindest des überwiegenden Teils der Längsachse des Resonators einen Bauch in der Magnetfeldstärke und einen Knoten in der elektrischen Feldstärke aufweist,
und wobei die Leistung der eingebrachten Mikrowelle und die Einkopplung der Mikrowelle in den Resonator (16) so abgestimmt sind, dass sich im Bereich zumindest eines Abschnitts der Leitung eine Amplitude der MW-Magnetfeldstärke ergibt, die mindestens 1·10⁻⁵ T, vorzugsweise mindestens 3·10⁻⁵ T beträgt.

2. Verfahren nach Anspruch 1, bei dem mindestens eine paramagnetische Substanz in dem Kontrastmittel gelöst oder mindestens eine imobilisierte paramagnetische Substanz vorgesehen ist, die im Fluss des Kontrastmittels angeordnet sind, wobei die paramagnetischen Substanzen insbesondere durch eine oder mehrere der folgenden Substanzen gebildet werden: stabile Radikale, insbesondere TEMPOL und dessen Derivate, Trityl, Kaliumnitrosodisulfonat, paramagnetische Übergangsmetallionen, durch ionisierte Strahlung erzeugte Radikale, und Moleküle im Triplett-Zustand.

3. Verfahren nach Anspruch 1 oder 2, bei dem eine Einrichtung nach einem der Ansprüche 4 bis 24 verwendet wird.

4. Einrichtung zur Hyperpolarisation eines flüssigen NMR-Kontrastmittels, die Folgendes umfasst:
eine Mikrowellen-Resonanzstruktur, mit einem MW-Resonator (16), der eine Längsachse aufweist,
eine Leitung (34) für das flüssige NMR-Kontrastmittel, die sich entlang der Längsachse des MW-Resonators (16) erstreckt,
eine Mikrowellen-Quelle (20) zum Erzeugen von Mikrowellen mit einer Frequenz von mindestens 40 GHz,
Mittel zum Einkoppeln von mit der MW-Quelle (20) erzeugen Mikrowellen in den MW-Resonator (16),
eine Pumpe (28), und eine Steuereinrichtung (38), die dazu eingerichtet ist, die Pumpe (28) derart zu steuern, dass das Kontrastmittel kontinuierlich durch die Leitung (34) im MW-Resonator (16) hindurch und zur Verabreichung an ein Lebewesen transportiert wird,
wobei die Geometrie des MW-Resonators (16), die Mittel zum Einkoppeln der Mikrowellen in den MW-Resonator (16), der Querschnitt der Leitung (34), die Leistung und die Frequenz der MW-Quelle (20) so aufeinander abgestimmt sind und die MW-Quelle (20) so eingerichtet ist, dass
- in dem MW-Resonator (16) eine MW-Mode ausgebildet wird, die entlang zumindest eines überwiegenden Teils der Längsachse des MW-Resonators einen Bauch in der Magnetfeldstärke und einen Knoten in der elektrischen Feldstärke aufweist, und
- im Bereich zumindest eines Abschnittes der Leitung (34) ein MW-Magnetfeld mit einer Amplitude von mindestens 1·10⁻⁵ T, vorzugsweise mindestens 3·10⁻⁵ T erzeugt wird.

5. Einrichtung nach Anspruch 4, mit
einer ersten Leitung (30), die geeignet ist, das Kontrastmittel von einem Reservoir (26) außerhalb einer Bohrung (12) eines MRT-Gerätes zu dem MW-Resonator (16) zu leiten, wenn dieser in der Bohrung (12) des MRT-Gerätes angeordnet ist, und/oder mit einer zweiten Leitung (36), die geeignet ist, das hyperpolarisierte Kontrastmittel von dem Resonator (16) zum Lebewesen (14) zu leiten, wenn sich der Resonator (16) und das Lebewesen (14) in einer Bohrung (12) eines MRT-Gerätes befinden.

6. Einrichtung nach Anspruch 5, bei der der Querschnitt der zweiten Leitung (36) geringer ist als derjenige der Leitung (34) im MW-Resonator (16).

7. Einrichtung nach einem der Ansprüche 4 bis 6, bei der der MW-Resonator (16) Abschnitte (40) aufweist, die zum Einstellen der Resonanzfrequenz relativ zueinander verstellbar sind, und Mittel (50, 52) zum Verstellen der Resonatorabschnitte (48) relativ zueinander umfasst, die vorzugsweise von außerhalb der Bohrung (12) des MRT-Gerätes zugänglich sind, wenn der MW-Resonator (16) in dieser angeordnet ist.

8. Einrichtung nach einem der Ansprüche 4 bis 7, bei der die Abmessungen des MW-Resonators (16) derart auf eine von der MW-Quelle (20) erzeugbare Frequenz abgestimmt sind, dass die MW-Frequenz einer MW-Mode im Resonator (16) entspricht, die bezüglich der Längsachse des Resonators eine Oberschwingung darstellt.

9. Einrichtung nach einem der Ansprüche 4 bis 8, bei der der MW-Resonator (16) an seiner dem MW-Feld zugewandten Oberfläche elektrisch leitend ist, wobei der MW-Resonator (16) vorzugsweise zumindest teilweise aus einem Trägermaterial (42, 48) besteht, welches an seiner dem MW-Feld zugewandten Oberfläche mit einer leitenden Schicht, insbesondere einer Silberschicht überzogen ist, wobei die leitende Schicht insbesondere mindestens 0,5 µm, vorzugsweise mindestens 1 µm und besonders vorzugsweise mindestens 2 µm dick ist, und/oder wobei das Trägermaterial vorzugsweise durch eines der folgenden Materialien gebildet wird: Bronze-, Messing- oder Rotgusslegierung, Aluminium, Kupfer, Neusilber, oder einen wasserstofffreien Kunststoff, insbesondere PCTFE, Vespel oder PTFE.

10. Einrichtung nach einem der Ansprüche 4 bis 9, mit einer Mehrzahl von Resonatoren (16), die parallel von Kontrastmittel durchflossen werden.

11. Einrichtung nach einem der Ansprüche 4 bis 10, mit einer Einrichtung (32) zum Temperieren, insbesondere Kühlen des Kontrastmittels, die in Flussrichtung des Kontrastmittels betrachtet vor dem MW-Resonator (16) angeordnet ist, und/oder mit einer Einrichtung zum Temperieren, insbesondere Kühlen des Kontrastmittels, die in Flussrichtung des Kontrastmittels betrachtet hinter dem Resonator (16) angeordnet ist.

12. Einrichtung nach einem der Ansprüche 4 bis 11, bei der der Resonator (16) ein Zylinderresonator ist, wobei die genannte Mode vorzugsweise eine TE₀₁₁-, eine TE₀₁₂-Mode oder eine TE_{01*n*}-Mode mit 2<*n*<100 ist.

13. Einrichtung nach Anspruch 12, bei der der MW-Resonator (16) einen zylindrischen Resonatorabschnitt aufweist, der an wenigstens einem Längsende durch einen entlang der Längsachse des Resonators verstellbaren Kolben (48) oder Stempel begrenzt wird, wobei der mindestens eine verstellbare Kolben (48) oder Stempel ein Außengewinde aufweist, welches mit einem am MW-Resonator (16) vorgesehenen Innengewinde im Eingriff ist, derart, dass der Kolben (48) bzw. Stempel durch Drehung um seine Achse in Richtung parallel zur Längsachse des Zylinderresonators (16) verstellbar ist.

14. Einrichtung nach Anspruch 12 oder 13, bei der der Zylinderresonator (16) einen Innendurchmesser von 8,4 bis 15 mm, vorzugsweise 8,7 bis 11 mm und besonders vorzugsweise 9,0 bis 9,4 mm hat, und/oder bei der der Zylinderresonator (16) in der Länge zwischen 11 und 12 mm, zwischen 22 und 24 mm, oder zwischen 11·*n* mm und 12. n mm einstellbar ist, wobei n eine ganze Zahl und 2<*n*<100 ist.

15. Einrichtung nach einem der Ansprüche 12 bis 14, bei der eine Iris (58) zum Einkoppeln der Mikrowellen in den MW-Resonator (16) vorgesehen ist, wobei die Iris insbesondere eine Schlitziris (58) ist, vorzugsweise eine Schlitziris (58) mit einer Schlitzbreite von 0,01 bis 1,00 mm, besonders vorzugsweise von 0,2 bis 0,4 mm und/oder mit einer Länge von 1 bis 10 mm, vorzugsweise 5 bis 7 mm ist, oder bei der die Iris (58) größenverstellbar ist, und/oder bei der Mittel zum Einkoppeln der magnetischen Komponente der Mikrowelle in den Resonator vorgesehen sind.

## Claims

1. A method for providing a hyperpolarized liquid contrast agent for use in a MRT device, in particular for administration to a living being (14) in a MRT device, comprising the following steps:
passing said liquid contrast agent through a conduit (34) extending along a longitudinal axis of a MW resonator (16) arranged in the magnetic field of said MRT device,
coupling of a microwave with a frequency of at least 40 GHz into said MW resonator (16) that is suitable for polarizing said liquid contrast agent upon its passage through said conduit (34) in said MW resonator (16) using DNP,
wherein said contrast agent, at least at times, is polarized in said MW resonator (16) during a continuous passage for the purpose of immediate administering to said living being,
wherein in said MW resonator (16), a MW mode is formed, which along at least the predominant part of said longitudinal axis of said resonator has an antinode in the magnetic field strength and a node in the electric field strength,
and wherein the power of the introduced microwave and the coupling of said microwave into said resonator (16) are adjusted such that in the area of at least a portion of said conduit an amplitude of the MW magnetic field strength is obtained which amounts to at least 1·10⁻⁵T, preferably at least 3·10⁻⁵T.

2. The method according to claim 1, wherein at least one paramagnetic substance is dissolved in said contrast agent or at least one immobilized paramagnetic substance is provided, which is arranged in the flow of said contrast agent, wherein said paramagnetic substances are in particular formed by one or more of the following substances: stable radicals, in particular TEMPOL and its derivatives, trityl, potassium ni-trosodisulfonate, paramagnetic transition metal ions, radicals generated by ionized radiation, and molecules in their triplet state.

3. The method according to claims 1 or 2, wherein an apparatus according to any of claims 4 to 24 is used.

4. An apparatus for hyperpolarization of a liquid NMR contrast agent, comprising:
a microwave resonance structure, with a MW resonator (16) having a longitudinal axis,
a conduit (34) for said liquid NMR contrast agent extending along said longitudinal axis of said MW resonator (16),
a microwave source (20) for generating microwaves with a frequency of at least 40 GHz,
means for coupling microwaves generated with said microwave source (20) into said MW resonator (16),
a pump (28) and a control device (38) configured to control the pump (28) suitable for continuously transporting said contrast agent through said conduit (34) in said MW resonator (16) and for administrating it to a living being,
wherein the geometry of said MW resonator (16), said means for coupling said microwaves into said MW resonator (16), the cross-section of said conduit (34), the power and the frequency of said MW source (20) are adjusted with respect to one another and the MW source (20) is configured such that
- in said MW resonator (16), a MW mode is formed, which along at least a predominant portion of said longitudinal axis of said MW resonator has an antinode in the magnetic field strength and a node in the electric field strength, and
- in the area of at least a portion of said conduit (34), a MW magnetic field having an amplitude of at least 1·10⁻⁵ T, preferably at least 3·10⁻⁵ T, is generated.

5. The apparatus according to claim 4, comprising
a first conduit (30) suitable for transporting said contrast agent from a reservoir (26) outside a bore (12) of a MRT device to said MW resonator (16), when said MW resonator (16) is arranged in said bore (12) of said MRT device, and/or
a second conduit (36) suitable for transporting said hyperpolarized contrast agent from said resonator (16) to said living being (14), when said resonator (16) and said living being (14) are located in a bore (12) of a MRT device.

6. The apparatus according to claim 5, wherein the cross-section of said second conduit (36) is smaller than that of said conduit (34) in said MW resonator (16).

7. The apparatus according to any of claims 4 to 6, wherein said MW resonator (16) has portions (40), which for setting the resonance frequency are adjustable relative to one another, and comprises means (50, 52) for adjusting the resonator portions (48) relative to one another, which are preferably accessible from outside said bore (12) of said MRT device, when said MW resonator (16) is arranged therein.

8. The apparatus according to any of claims 4 to 7, wherein the dimensions of said MW resonator (16) are tuned to a frequency, which can be generated by said MW source (20), such that the MW frequency corresponds to a MW mode in the resonator (16), which in respect of said longitudinal axis of said resonator represents a harmonic.

9. The apparatus according to any of claims 4 to 8, wherein said MW resonator (16) is electrically conductive at its surface facing the MW field, wherein
said MW resonator (16) preferably at least partially consists of a carrier material (42, 48), which at its surface facing said MW field is coated with a conductive layer, in particular a silver layer,
wherein said conductive layer in particular has a thickness of at least 0.5 µm, preferably at least 1 µm, and particularly preferred at least 2 µm, and/or
wherein said carrier material is formed by any of the following materials: bronze, brass or red brass alloys, aluminum, copper, nickel silver, or a hydrogen-free plastic, in particular PCTFE, Vespel, or PTFE.

10. The apparatus according to any of claims 4 to 9, comprising a multitude of resonators (16), through which contrast agent flows in parallel.

11. The apparatus according to any of claims 4 to 10, comprising an apparatus (32) for temperating, in particular cooling, of said contrast agent, arranged in upstream of said MW resonator (16) when viewed in the flow direction of said contrast agent, and/or
an apparatus for temperating, in particular cooling, of said contrast agent, arranged downstream of said MW resonator (16), when viewed in the flow direction of said contrast agent.

12. The apparatus according to any of claims 4 to 11, wherein said resonator (16) is a cylinder resonator, wherein
the aforementioned mode is preferably a TE₀₁₁, a TE₀₁₂ or a TE_{01*n*} mode with 2<*n*<100.

13. The apparatus according to claim 12, wherein said MW resonator (16) has a cylindrical resonator portion, which at least at one longitudinal end is terminated by a piston (48) or prop adjustable along said longitudinal axis of said resonator,
wherein said at least one adjustable piston (48) or prop has an external thread engaged with an internal thread provided at said MW resonator (16), such that said piston (48) or prop, respectively, is adjustable in the direction in parallel to said longitudinal axis of said cylinder resonator (16) by rotation around its axis.

14. The apparatus according to any of claims 12 or 13, wherein said cylinder resonator (16) has an internal diameter of 8.4 to 15 mm, preferably 8.7 to 11 mm, and particularly preferred 9.0 to 9.4 mm, and/or
wherein said cylinder resonator (16) can be adjusted in its length between 11 and 12 mm, between 22 and 24 mm, or between 11·*n* mm and 12·*n* mm, wherein *n* is an integer and 2<*n*<100.

15. The apparatus according to any of claims 12 to 14, wherein an iris (58) is provided for coupling said microwaves into said MW resonator (16),
wherein said iris is in particular a slit iris (58), preferably a slit iris (58) with a slit width of 0.01 to 1.00 mm, particularly preferred from 0.2 to 0.4 mm, and/or with a length of 1 to 10 mm, preferably 5 to 7 mm, or
wherein said iris (58) can be adjusted in size, and/or
wherein means for coupling the magnetic component of said microwave into said resonator are provided.

## Revendications

1. Procédé de mise à disposition d'un produit de contraste liquide hyper-polarisé destiné à être utilisé dans un appareil MRT, plus particulièrement pour une administration à un être vivant (14) dans un appareil MRT, avec les étapes suivantes :
passage du produit de contraste liquide dans une conduite (34), qui s'étend le long d'un axe longitudinal d'un résonateur MW (16), qui est disposé dans le champ magnétique de l'appareil MRT,
introduction d'une micro-onde avec une fréquence d'au moins 40 GHz dans le résonateur MW (16), qui est conçu pour polariser le produit de contraste liquide lors de son écoulement à travers la conduite (34) dans le résonateur MW (16) grâce à une DNP,
le produit de contraste étant polarisé au moins par phases dans un écoulement continu dans le résonateur MW (16) pour une administration directe à l'être vivant,
moyennant quoi, dans le résonateur MW, un mode MW étant réalisé, qui présente, le long d'au moins la majeure partie de l'axe longitudinal du résonateur, un ventre dans l'intensité du champ magnétique et un noeud dans l'intensité du champ électrique,
et la puissance de la micro-onde introduite et l'introduction de la micro-onde dans le résonateur (16) étant adaptées de façon à ce que, au niveau d'au moins une portion de la conduite, il résulte une amplitude de l'intensité du champ magnétique MW, qui est d'au moins 1·10⁻⁵T, de préférence d'au moins 3·10⁻⁵T.

2. Procédé selon la revendication 1, dans lequel au moins une substance paramagnétique est dissoute dans le produit de contraste ou au moins une substance paramagnétique immobilisée est prévue, qui sont disposées dans le flux du produit de contraste, les substances paramagnétiques étant constituée plus particulièrement d'une ou plusieurs des substances suivantes : radicaux stables, plus particulièrement TEMPOL et ses dérivés, sulfonate de sodium de nitrate de potassium, des ions métalliques de transition paramagnétiques, radicaux générés à partir d'un rayonnement ionisé et molécules à l'état de triplet.

3. Procédé selon la revendication 1 ou 2, dans lequel un dispositif selon l'une des revendications 4 à 24 est utilisé.

4. Dispositif pour l'hyper-polarisation d'un produit de contraste NMR liquide qui comprend ce qui suit :
une structure de résonance à micro-ondes, avec un résonateur MW (16), qui comprend un axe longitudinal,
une conduite (34) pour le produit de contraste NMR liquide , qui s'étend le long de l'axe longitudinal du résonateur MW (16),
une source de micro-ondes (20) pour la production de micro-ondes avec une fréquence d'au moins 40 GHz,
des moyens pour l'introduction de micro-ondes générées avec la source MW (20) dans le résonateur MW (16),
une pompe (28) et un dispositif de commande (38), qui est conçu pour contrôler la pompe (28) de façon à ce que le produit de contraste soit transporté de manière continue à travers la conduite (34) dans le résonateur MW (16), pour l'administration à un être vivant,
la géométrie du résonateur MW (16), les moyens d'introduction des micro-ondes dans le résonateur MW (16), la section de la conduite (34), la puissance et la fréquence de la source MW (20) étant adaptés entre eux et la source MW (20) étant conçue de façon à ce que
- dans le résonateur MW (16), un mode MW est réalisé, qui comprend, le long d'au moins une majeure partie de l'axe longitudinal du résonateur MW, un ventre dans l'intensité du champ magnétique et un noeud dans l'intensité du champ électrique et
- au niveau d'au moins une portion de la conduite (34), un champ magnétique MW avec une amplitude d'au moins 1.10⁻⁵ T, de préférence d'au moins 3.10⁻⁵ T est généré.

5. Dispositif selon la revendication 4, avec
une première conduite (30), qui est conçu pour conduire le produit de contraste d'un réservoir (26) à l'extérieur d'un alésage (12) d'un appareil MRT vers le résonateur MW (16), lorsque celui-ci est disposé dans l'alésage (12) de l'appareil MRT et/ou avec une deuxième conduite (36), qui est conçue pour conduire le produit de contraste hyper-polarisé du résonateur (16) vers l'être vivant (14) lorsque le résonateur (16) et l'être vivant (14) se trouvent dans un alésage (12) d'un appareil MRT.

6. Dispositif selon la revendication 5, dans lequel la section de la deuxième conduite (36) est plus petite que celle de la conduite (34) dans le résonateur MW (16).

7. Dispositif selon l'une des revendications 4 à 6, dans lequel le résonateur MW (16) comprend des portions (40) qui sont mobiles les unes par rapport aux autres pour le réglage de la fréquence de résonance et des moyens (50, 52) pour le déplacement des portions du résonateur (48) les unes par rapport aux autres, qui sont accessibles de préférence de l'extérieur de l'alésage (12) de l'appareil MRT, lorsque le résonateur MW (16) est disposé dans celui-ci.

8. Dispositif selon l'une des revendications 4 à 7, dans lequel les dimensions du résonateur MW (16) sont adaptées à une fréquence pouvant être générée par la source MW (20) de façon à ce que la fréquence MW corresponde à un mode MW dans le résonateur (16), qui constitue une harmonique par rapport à l'axe longitudinal du résonateur.

9. Dispositif selon l'une des revendications 4 à 8, dans lequel le résonateur MW (16) est électriquement conducteur au niveau de sa surface orientée vers le champ MW, le résonateur MW (16) étant de préférence constitué au moins partiellement d'un matériau de support (42, 48), qui est recouvert, au niveau de sa surface orientée vers le champ MW, d'une couche conductrice, plus particulièrement d'une couche d'argent, la couche conductrice présentant une épaisseur d'au moins 0,5 µm, de préférence d'au moins 1 µm et plus particulièrement de préférence d'au moins 2 µm et/ou le matériau de support étant constitué de préférence d'un des matériaux suivants : alliage de bronze, de laiton ou de bronze, aluminium, cuivre, maillechort ou une matière plastique sans hydrogène, plus particulièrement du PCTFE, du Vespel ou du PTFE.

10. Dispositif selon l'une des revendications 4 à 9, avec une pluralité de résonateurs (16), qui sont traversés parallèlement par un produit de contraste.

11. Dispositif selon l'une des revendications 4 à 10, avec un dispositif (32) pour le réglage de température, plus particulièrement le refroidissement du produit de contraste, qui est disposé, vu dans le sens d'écoulement du produit de contraste, avant le résonateur MW (16) et/ou
avec un dispositif pour le réglage de la température, plus particulièrement le refroidissement du produit de contraste, qui est disposé, vu dans le sens d'écoulement du produit de contraste, derrière le résonateur (16).

12. Dispositif selon l'une des revendications 4 à 11, dans lequel le résonateur (16) est un résonateur cylindrique, le mode mentionné étant de préférence un mode TE₀₁₁, un mode TE₀₁₂ ou un mode TE₀₁ₙ, avec 2<*n*<100.

13. Dispositif selon la revendication 12, dans lequel le résonateur MW (16) comprend une portion de résonateur cylindrique, qui est délimitée, au niveau d'au moins une extrémité longitudinale par un piston (48) ou un poinçon mobile le long de l'axe longitudinal du résonateur, l'au moins un piston (48) ou poinçon mobile comprenant un filetage externe qui s'emboîte avec un filetage interne prévu sur le résonateur MW (16) de façon à ce que le piston (48) ou le poinçon puisse être déplacé par une rotation autour de son axe parallèlement à l'axe longitudinal du résonateur cylindrique (16).

14. Dispositif selon la revendication 12 ou 13, dans lequel le résonateur cylindrique (16) présente un diamètre intérieur de 8,4 à 15 mm, de préférence de 8,7 à 11 mm et de préférence de 9,0 à 9,4 mm, et/ou dans lequel le résonateur cylindrique (16) est réglable en longueur entre 11 et 12 mm, entre 22 et 24 mm ou entre 11.n mm et 12.n mm, n étant un entier et 2<n<100.

15. Dispositif selon l'une des revendications 12 à 14, dans lequel un iris (58) est prévu pour l'introduction des micro-ondes dans le résonateur MW (16), l'iris étant plus particulièrement un iris à fente (58), de préférence un iris à fente (58) avec une largeur de fente de 0,01 à 1,00 mm, de préférence de 0,2 à 0,4 mm et/ou avec une longueur de 1 à 10 mm, de préférence de 5 à 7 mm ou dans lequel l'iris (58) présente une taille réglable et/ou dans lequel des moyens sont prévus pour l'introduction de la composante magnétique de la micro-onde dans le résonateur.
